# FASCICULE DE BREVET EUROPEEN

(11) **EP 2 636 227 B1**
(45) Date de publication et mention de la délivrance du brevet: **30.03.2016**
(21) Numéro de dépôt: 11832126.4
(22) Date de dépôt: 27.10.2011
(51) Int. Cl.: H04R 3/14, H04R 1/26

(54) **ENCEINTE ACOUSTIQUE MULTI-VOIES**
MEHRKANALLAUTSPRECHER
MULTICHANNEL LOUDSPEAKER

(30) Priorité: 03.11.2010 FR 1059059
(43) Date de publication de la demande: 11.09.2013
(73) Titulaire: FOCAL JMLab, 42350 La Talaudière (FR)
(72) Inventeur: DEBARD, Nicolas, F-42560 Margerie-Chantagret (FR); PARES, Benjamin, F-69007 Lyon (FR)
(74) Mandataire: Cabinet Laurent & Charras
(86) Numéro de dépôt international: PCT/FR2011/052510
(87) Numéro de publication internationale: WO 2012/059668

(56) Documents cités:
- US-A- 4 181 819
- US-A1- 2003 215 097
- US-A1- 2008 170 722

## Description

### Domaine technique

L'invention se rattache au domaine des enceintes acoustiques. Elle vise plus particulièrement un type d'enceintes incluant des agencements permettant de les utiliser pour plusieurs types de rendu sonore, afin de simuler l'écoute sur divers types de matériel.

### Techniques antérieures

De façon générale, dans les studios d'enregistrement, ou plus généralement lors de la réalisation de mixage de pistes audio en vue de la production et la diffusion d'oeuvres sonores, on recherche la meilleure qualité d'écoute. C'est pourquoi on utilise des enceintes ou moniteurs de studio de haute performance, afin que le rendu sonore soit le plus fidèle, puisqu'il sera ensuite en quelque sorte « figé » dans un support physique ou informatique avant la diffusion.

Afin de s'approcher au plus près de la fidélité absolue, les enceintes acoustiques présentent, la plupart du temps, plusieurs voies, comportant chacune un ou plusieurs haut-parleurs spécialisés pour chaque bande de fréquences à reproduire. On trouve au minimum de deux voies dédiées de façon générale à la reproduction des graves et des aigus. Dans certains systèmes, le nombre de voies peut monter jusqu'à six, avec une segmentation spectrale en fréquence qui peut se décomposer ainsi : extrême grave (fréquences inférieures à 50Hz), grave (<150Hz), bas-médium (< 600Hz), médium (<2500Hz), aigus (<20000Hz) et extrême aigus (>20000Hz).)

Ces enceintes émettent avec des degrés élevés de détails, similaires à ceux que pourront entendre les utilisateurs équipés de matériel de haute gamme.

Cependant, il est également important que l'ingénieur du son ou de manière plus générale, la personne assurant ce mixage ; puisse vérifier que le rendu sonore sera également de bonne qualité lorsqu'il sera diffusé par l'intermédiaire d'un matériel acoustique possédant un rendu sonore différent, et en particulier sur des enceintes ne possédant que deux voies, voire une seule. A titre d'illustration, un des objectifs du mixage est d'assurer un rendu sonore d'une oeuvre musicale qui soit acceptable qu'elle soit diffusée sur un système de haute fidélité à enceintes perfectionnées quadri-voies, ou qu'elle soit reproduite sur un système multimédia connecté à un ordinateur, ou bien encore par le système audio d'un véhicule, voire encore par un simple haut-parleur de radioréveil.

Ainsi, une manière simple de vérifier que le signal émis par une enceinte trois voies est également de qualité suffisante chez des enceintes deux voies, consiste à installer ces deux types d'enceintes dans la pièce d'écoute, et d'assurer successivement la connexion de l'une ou l'autre des deux enceintes. Cette solution est bien entendu encombrante et peu pratique. En d'autres termes, pour vérifier la qualité de transfert sur différents types d'enceintes, c'est-à-dire des enceintes différant en terme de nombre de voies, de l'équilibre tonal et de la bande de fréquence reproduite, il est nécessaire d'installer d'autant de paires d'enceintes et d'assurer successivement la connexion de chacune des paires.

Une autre solution consiste à insérer une égalisation dans la partie filtrage de l'enceinte, ce qui modifie son équilibre tonal et donne ainsi la perception d'un autre rendu sonore. Cependant, ce type d'enceinte émet toujours sur l'ensemble de ses voies, ce qui ne permet pas de prendre en compte les spécificités d'une enceinte possédant un nombre de voies inférieur à celle du moniteur de studio utilisé. Ces spécificités sont entre autres le délai de groupe dans les basses fréquences et l'effet Doppler dû au mouvement de grande amplitude de la membrane du haut-parleur de grave parasitant le registre médium.

Le document US 2008/0170722 décrit une enceinte à deux voies, qui peut fonctionner selon deux modes, à savoir un mode où les deux voies sont actives, et un mode particulier où seule la voie grave est opérationnelle, la voie aigue ayant été déconnectée. Une telle enceinte ne permet pas d'avoir un rendu sonore de l'ensemble du spectre audible lorsqu'elle fonctionne dans ce mode particulier.

### Exposé de l'invention

Un problème que cherche à résoudre l'invention est donc celui de pouvoir obtenir plusieurs types de rendu sonore distincts, au moyen d'une seule enceinte acoustique, en obtenant en particulier un rendu identique à celui d'une enceinte deux voies au moyen d'une enceinte à trois voies, pour mettre en oeuvre un mode dit de « voicing ».

L'invention concerne donc l'enceinte acoustique comportant au moins deux voies, dans laquelle une première et une seconde voie sont dédiées respectivement à une première et à une seconde bandes de fréquence distinctes et adjacentes, c'est-à-dire des bandes qui présentent une frontière commune ou proche. Il peut par exemple s'agir de la bande de fréquences dédiées aux graves et de la bande dédiée aux bas médiums, ou encore des médiums et des aigus.

Chaque voie inclut notamment un étage de filtrage alimenté par le signal de commande, ainsi qu'un haut-parleur, et le cas échéant un étage amplificateur. Cette enceinte comporte des moyens pour déconnecter la première voie du signal de commande,

Conformément à l'invention, cette enceinte acoustique se caractérise en ce qu'elle comprend également des moyens pour concommitamment à la déconnexion de la première voie du signal de commande, modifier l'étage de filtrage de la seconde voie afin de modifier sa réponse en fréquence, et déplaçant la fréquence de coupure de la seconde voie en direction de la bande de fréquence de la voie qui a été déconnectée. Une telle modification de la réponse en fréquence peut également s'accompagner d'une modification de l'équilibre tonal.

Autrement dit, à partir d'une enceinte multi-voies, l'invention permet de déconnecter un ou plusieurs haut-parleurs dédiés à des bandes de fréquences spécifiques. Concomitamment, le filtrage des voies toujours actives est changé, par exemple pour prendre en charge une partie des fréquences reproduites par les haut-parleurs déconnectés, et compenser au moins partiellement ces déconnexions pour couvrir au global l'essentiel du spectre audible. De cette manière, on modifie le rendu sonore des voies restant actives pour le rapprocher de celui d'un système audio que l'on souhaite émuler.

Ainsi, dans le cas particulier d'une enceinte trois voies, l'invention permet de déconnecter le haut-parleur dédié aux fréquences basses, qui est absent dans les enceintes deux voies, de sorte qu'aucun son n'est émis par ce haut-parleur. Complémentairement, le filtrage associé aux fréquences mediums est modifié pour prendre en compte une partie des fréquences basses reproduites classiquement sur le haut-parleur dédié aux basses fréquences.

En d'autres termes, on assure dans ce cas une diffusion uniquement par les haut-parleurs dédiés aux hautes fréquences et aux médiums, grâce à la coupure physique de l'alimentation du haut-parleur dédié aux basses fréquences. Cette coupure se fait toutefois en intégrant dans le signal d'alimentation du haut-parleur médium, des fréquences qui seraient originalement reproduites par le haut-parleur de basse fréquence.

La modification du filtrage de la ou des voies restantes peut se faire en combinant de multiples fonctions telles que des filtrages passe-haut, passe-bas, passe-tout, ou encore des fonctions de type « low-shelving », ou encore des actions sur la phase. Ces combinaisons peuvent être déclinées en fonction des rendus sonores recherchés. Dans le cas où la modification du filtrage se fait sans modification de fréquences de coupures constantes, mais avec une modification de l'équilibre tonal, des « accidents » peuvent être introduits sur la réponse en fréquence, à des endroits particuliers du spectre, définis pour obtenir un rendu sonore identique ou similaire à celui du système audio que l'on cherche à émuler.

Dans un cas particulier de réalisation, lorsque l'enceinte fonctionne avec ses trois voies actives, l'étage de filtrage de la seconde voie, c'est-à-dire généralement la voie médium, peut comporter un filtre passe-haut, présentant une fréquence de coupure basse F_{OFF}. Lorsque l'enceinte est utilisée dans le mode ne comportant que deux voies, cet étage de filtrage peut être modifié pour inclure un filtrage passe-haut avec une fréquence de coupure basse F_{ON} inférieure à F_{OFF}, avantageusement combiné à une atténuation constante à une fréquence F_{LS} inférieure à F_{ON}

Autrement dit, la fréquence de filtrage de l'étage dédié aux .médiums voit sa fréquence de coupure basse diminuée lorsque l'enceinte fonctionne en mode « voicing ». Complémentairement, l'étage de filtrage, modifié lorsque la fonction voicing est activée, inclut une atténuation constante à partir d'une fréquence F_{LS} inférieure à F_{ON}. De la sorte, les fréquences médiums sont quelque peu atténuées au profit des fréquences basses qui, au contraire, doivent être légèrement amplifiées afin que leur rendu sonore soit satisfaisant, au travers du haut-parleur dédié à la fréquence médium.

Dans certains cas de figure, en fonction des étendues des bandes passantes des voies concernées, il peut être utile de modifier les pentes de filtrage des haut-parleurs continuant à émettre, ce qui permet d'obtenir un rendu acoustique différent. En effet, changer les pentes de filtrage a pour conséquences (entre autres) de modifier l'énergie présente dans la bande coupée, mais aussi de modifier les lobes de directivité de l'enceinte, et de changer le délai de groupe du système, autour et en dessous de la fréquence de raccordement. Ceci participe à la modification du comportement acoustique global de l'enceinte en mode "voicing", par rapport à celui d'origine. La modification des pentes de filtrage s'obtient par l'ajout, ou le retrait, de cellules de filtre passe-haut et/ou passe-bas, aux cellules de filtrages déjà présentes. De plus, il peut être également intéressant de les combiner avec une ou plusieurs cellules de filtres passe-tout afin d'ajuster la mise en phase des deux haut-parleurs à la fréquence de raccordement.

Le principe analogue peut-être adopté de façon symétrique dans le cas où la première voie, qui est coupée en mode « voicing », correspond à une bande plus haute en fréquence que la voie qui est modifiée pour la compenser. Dans ce cas, le filtrage passe-bas de la seconde voie est modifié en remontant sa fréquence de coupure haute F'_{ON}. Il est également possible d'adjoindre un étage de filtrage de type « low-shelving », assurant avec une atténuation des fréquences en dessous d'une fréquence de référence F'_{LS} située au dessus de la fréquence de coupure haute du filtre passe bas modifié.

Selon un mode de réalisation particulier de réalisation, chaque voie non déconnectée lorsque le mode « voicing » est actif peut comporter deux circuits de filtrage distincts alimentés en entrée par le même signal et dont les sorties sont connectées alternativement au haut-parleur de la voie en question, selon l'état d'un commutateur permettant l'activation ou la désactivation mode « voicing ». En pratique, cette commutation peut avoir lieu de différentes manières, à savoir soit de manière mécanique, électromécanique, ou encore de façon préférée, par actionnement d'interrupteurs statiques associées aux étages de filtrages, et commandés de façon manuelle ou électronique.

Autrement dit, l'enceinte comporte des circuits électroniques assurant les différentes fonctions de filtrage dédiées à l'étage du haut-parleur intégrés aux voies non déconnectées en mode « voicing » actif, qui sont actionnés alternativement et exclusivement l'un de l'autre selon l'activation d'un organe prévu à cet effet sur l'enceinte ou bien encore une commande électronique déportée.

L'invention peut se généraliser à des cas où l'enceinte est apte à fournir plus de deux rendus sonores, auquel cas chaque voie comporte alors autant d'étages de filtrages que de modes possibles, commutables de façon analogue.

En pratique, les filtrages de chaque voies peuvent être réalisés en utilisant des circuits passifs, actifs, ou des techniques de filtrage numérique, ou encore une combinaison de ces différents modes le cas échéant. Les étages de filtrage peuvent être implantés dans le bâti même de l'enceinte, ou dans un boitier annexe, sans sortir du cadre de la présente invention. L'étendue de la présente invention est définit par les revendications.

### Description sommaire des figures

La manière de réaliser l'invention ainsi que les avantages qui en découlent ressortiront bien de la description du mode de réalisation qui suit, à l'appui des figures annexées dans lesquelles :
La figure 1 est un schéma électrique simplifié d'une enceinte conforme à l'invention.
Les figures 2 et 3 sont des diagrammes illustrant les réponses en fréquence de chacune des voies d'une enceinte conforme à l'invention, montrées lorsque la fonction de « voicing » est respectivement désactivée et activée.
Les figures 4 à 7 sont des schémas électriques simplifiés d'enceintes selon différents modes d'exécution de l'invention.

### Manières de réaliser l'invention

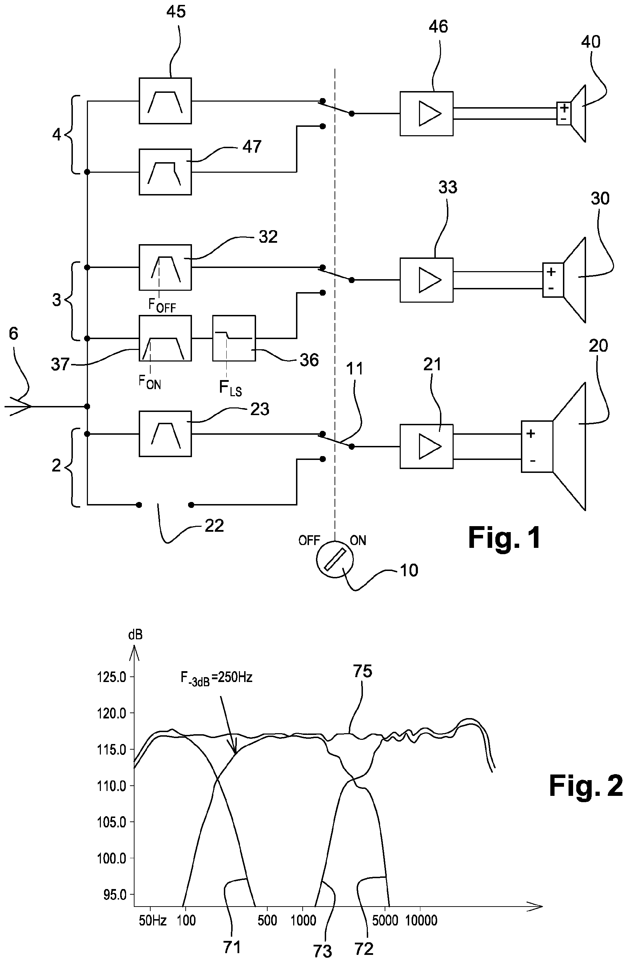

Tel qu'illustré à la figure 1, l'enceinte **1** réalisée conformément à l'invention possède trois voies **2, 3, 4** destinées à alimenter chacune un haut-parleur, à savoir un premier haut-parleur **20** dédié à la reproduction des sons à fréquences basses, d'un second haut-parleur **30,** de moindre diamètre, dédié à la reproduction des fréquences dans une bande médium, et un troisième haut-parleur **40** ou tweeter affecté à la reproduction des sons aigus

Chacune de ces voies **2, 3, 4** est alimentée par le signal d'entrée **6.** Ce signal **6** est appliqué sur chacune des voies qui comportent chacun son propre circuit de filtrage.

Ainsi, la voie **4** dédiée aux aigus possède un étage de filtrage qui inclut un filtre passe bande **45,** et un amplificateur **46** conçu de façon traditionnelle. Dans la forme illustrée à la figure 1, la voie dédiée aux aigus comporte un second étage de filtrage **47** qui est optionnel, et qui est opérationnel lorsque le mode « voicing » est actif. Ce filtrage **47** présente une réponse en fréquence différente du filtrage 45, de manière à réduire la qualité de rendu sonore, pour simuler un système audio de moindre fidélité, lorsque le mode « voicing » est actif.

De son côté, la voie **2** dédiée à la reproduction des basses fréquences possède également un étage de filtrage, qui inclut un filtre passe-bande **23,** présentant une fréquence basse de coupure de l'ordre de quelques dizaines de Hertz et une fréquence de coupure haute de l'ordre de 100 à 200Hz, destinée à éviter le recouvrement avec la bande de fréquence dédiée à la voie **3** affectée aux fréquences médiums.

En aval de cet étage de filtrage **23** se trouve le contact **11** d'un commutateur **10** qui permet de connecter la sortie de cet étage de filtrage à l'amplificateur **21,** ou de déconnecter l'étage de filtrage **23,** tel que représenté par le circuit ouvert **22 ,** et plus généralement en rendant inactive la voie **2** du haut-parleur des basses.

Le circuit de filtrage affecté à la seconde voie **3,** ou voie médium, comporte deux étages **32,34** qui sont actifs lorsque le mode « voicing » est respectivement activé ou non. L'étage actif lorsque le mode « voicing » est désactivé, comporte un filtrage de type passe bande, dont la fréquence haute de coupure est destinée à éviter le recouvrement avec la bande de fréquence affectée à la voie aigue **4,** qui est typiquement de l'ordre de quelques milliers de Hertz. Ce filtre présentant une fréquence de coupure F_{OFF}., permettant d'éviter le recouvrement de fréquence avec la voie basse **2** lorsque cette dernière est active, c'est-à-dire lorsque le mode « voicing » est désactivé.

Le circuit de filtrage **34** actif lorsque le mode « voicing » est opérationnel, comporte quant à lui un filtrage **37** passe-bande, présentant une fréquence de coupure basse F_{ON}, inférieure à la fréquence F_{OFF} de coupure basse du filtre **32** actif lorsque le mode « voicing » est désactivé.

Typiquement, cette fréquence de coupure **F_{ON}** peut être de l'ordre de 100 Hertz, à comparer avec une fréquence **F_{OFF}** de 200 Hertz lorsque la voie médium est utilisée de façon nominale.

L'étage de filtrage **34** comporte également un atténuateur **36,** de type « low-shelving » présentant une fréquence critique Fₛ permettant d'atténuer les fréquences couvrant les médiums ainsi qu'une bonne partie des fréquences basses, tout en conservant une prédominance du segment inférieur des fréquences basses. Ceci joue un rôle dans l'optimisation du couplage acoustique des voies entre elles.

Les deux étages de filtrage **32,34** sont reliés à deux contacts du commutateur 10, de manière à être alternativement reliés à un amplificateur **33** conçu de manière classique. Ainsi, lorsque le commutateur **10** permettant de sélectionner le mode « voicing » est en position « off », la voie basse **2** est alimentée, et la voie médium 3 comprend un étage de filtrage composé du filtre passe bande **32**

A l'inverse, lorsque le mode « voicing » est activé, la voie basse **2** est déconnectée et le filtrage de la voie médium **3** combine le filtrage passe bande **37** et l'étage de « low shelving » **36,** qui est relié à l'amplificateur **33.**

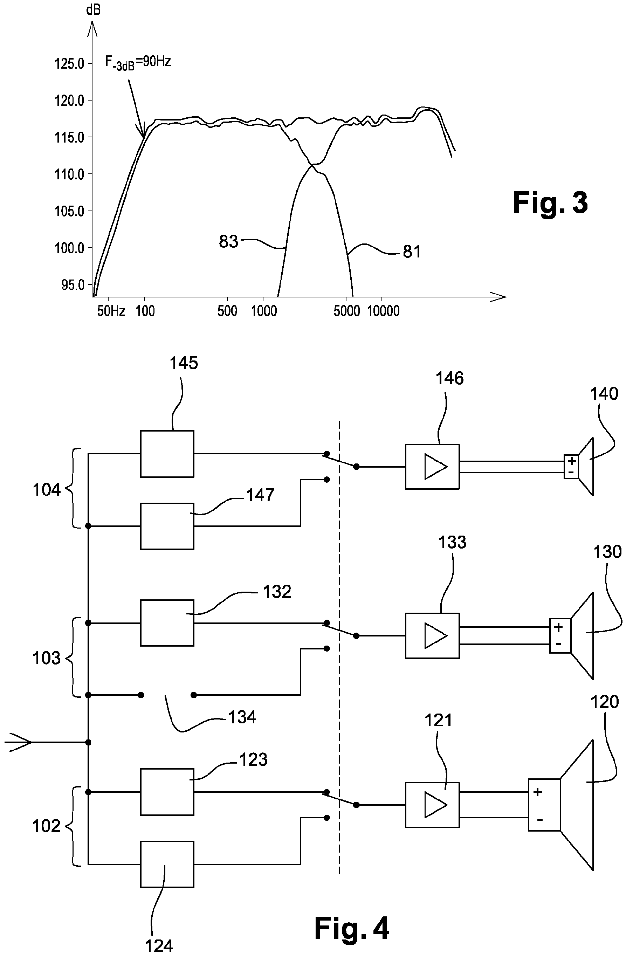

Les réponses en fréquence selon les deux modes de réalisation de fonctionnement sont illustrées aux figures 2 et 3.

Ainsi, on observe à la figure 2 que chacune des voies présentent une réponse en fréquence propre, la voie grave étant représentée par la courbe **71,** la voie médium par la courbe **72** et la voie aigue par la courbe **73.** La réponse globale correspond à la courbe **75,** dont on voit qu'elle s'étend nettement dans la bande de fréquence basse.

On note que la fréquence de coupure à -3dB pour la voie médium 3 se situe à une fréquence de l'ordre de 250 Hertz. Lorsque le mode « voicing » est activé comme illustré à la figure 3, la voie médium se retrouve avec une réponse en fréquence élargie, représentée par la courbe **81.** La voie aigue conserve la même réponse en fréquence, représentée par la courbe **83.**

On constate que la réponse en fréquence de la voie médium présente une fréquence de coupure nettement plus basse, de l'ordre de 90 Hertz environ, grâce au filtrage passe haut **35** de l'étage **34,** dont la fréquence de coupure **Fₒₙ** est de l'ordre de 100 Hertz. Ce mode de réalisation présente un intérêt pour l'émulation de systèmes de type « multimédia » à deux voies, qui possèdent une réponse en fréquence peu étendue dans le grave.

Bien entendu, les différentes valeurs et les formes de courbes représentées ne le sont qu'à titre indicatif, et l'invention couvre d'autres variantes dans lesquelles ces valeurs et ces formes sont adaptées en fonction des géométries et d'autres caractéristiques de l'enceinte.

Le principe de l'invention peut être décliné dans d'autres formes de réalisation. Un autre exemple est illustré à la figure 4, dans lequel c'est la voie des médiums **103** qui est déconnectée (tel que représenté par le circuit ouvert **134)** lorsque le mode « voicing » est activé. Dans ce cas, l'étage de filtrage **124** de la voie des basses **102** employé en mode « voicing », présente une réponse en fréquence étendue vers le haut, en comparaison à l'étage de filtrage **123** opérationnel lorsque le mode « voicing » est inactif. Il est également possible que le filtrage de la voie **104** des aigus soit modifié, de telle sorte que la fréquence de coupure basse de l'étage **147** soit plus basse que celle de l'étage **145** opérationnel lorsque le mode « voicing » n'est pas activé.

Ce type d'enceinte permet d'émuler par exemple les petits systèmes de sonorisation, qui sont très démonstratifs dans la grave, mais qui ont peu de définition dans le médium.

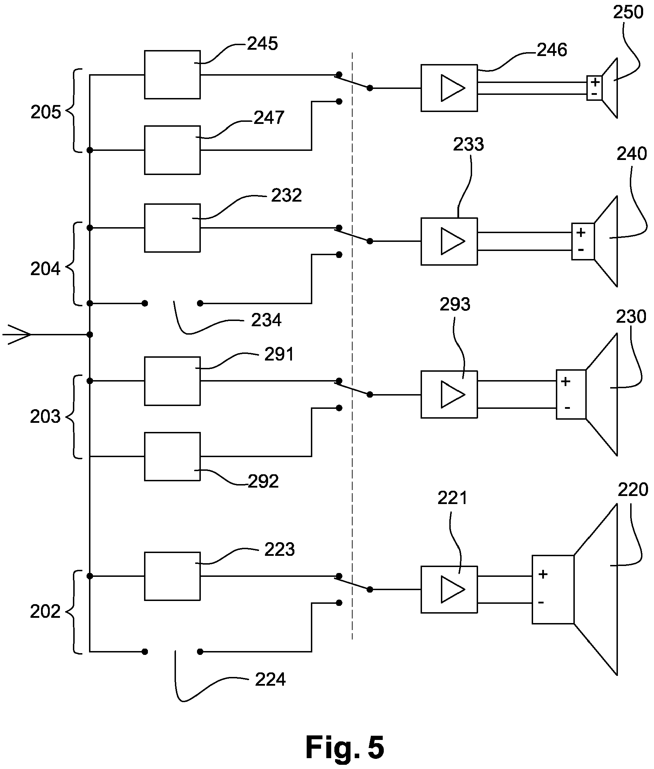

Dans l'exemple illustré à la figure 5, l'enceinte possède quatre voies, à savoir une voie basse **202,** alimentant un woofer **220,** une voie **203** dédiée aux bas-médiums, alimentant le haut-parleur **230,** une voie **204** dédiée aux médiums alimentant le haut-parleur **240,** et une voie **205** alimentant un « tweeter ». En mode nominal, c'est-à-dire lorsque toutes les voies fonctionnent, chaque voie possède son étage de filtrage **223,291,232,245** permettant de tirer le meilleur de performances des haut-parleurs correspondants **220,230,240,250.**

Lorsque le mode « voicing » est activé, la voie **204** dédiée aux médiums, et la voie **202** dédiée aux basses sont déconnectées, comme représenté par l'insertion des circuits ouverts **224, 234.** De façon similaire à l'exemple de la figure 1, le filtrage **292** appliqué alors à la voie bas-médium **203** permet de prendre en charge une partie des fréquences de la voie basse **202** maintenant inactive. De façon analogue, le filtrage **247** de la voie aigüe **205** présente une fréquence de coupure basse qui est abaissée par rapport à l'étage de filtrage **245,** de façon à ce que la voie aigue émette une partie des fréquences médium.

Ce type de montage permet en particulier d'émuler les systèmes audio de véhicule.

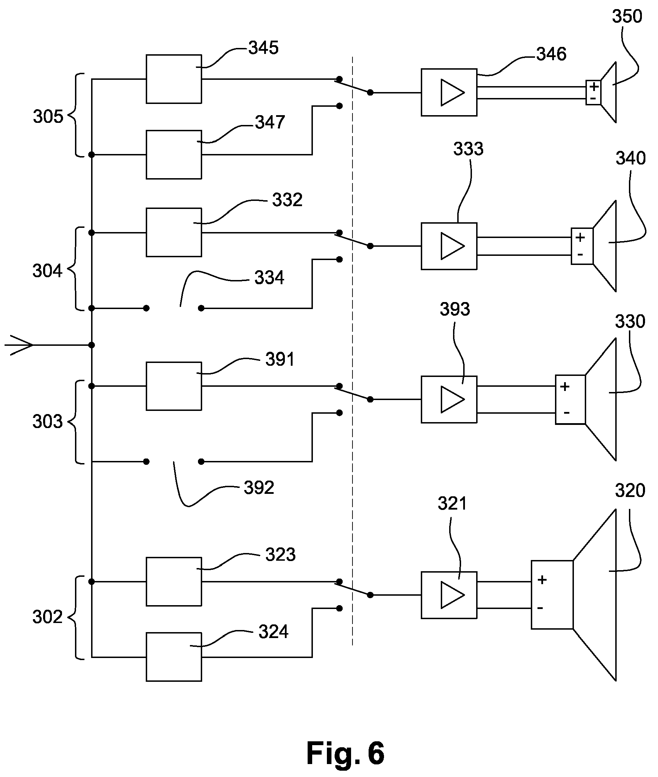

Dans l'exemple illustré à la figure 6, l'enceinte comporte également quatre voies **302,303,304,305.** En mode nominal, c'est-à-dire lorsque toutes les voies fonctionnent, chaque voie possède son étage de filtrage **323,391,332,345** permettant de tirer le meilleur de performances des haut-parleurs correspondants **320,330,340,350.**

Lorsque le mode « voicing » est activé, la voie **304** dédiée aux médiums, et la voie **303** dédiée aux bas-médiums sont déconnectées, comme représenté par l'insertion des circuits ouverts **334, 392.** De façon similaire à l'exemple de la figure 4, le filtrage **324** appliqué alors à la voie basse **302** permet de prendre en charge une partie des fréquences de la voie bas-médium **303** maintenant inactive. De façon analogue, le filtrage **347** de la voie des aigus présente une fréquence de coupure basse qui est abaissée par rapport à l'étage de filtrage **345,** de façon à ce que la voie aigue émette une partie des fréquences médium.

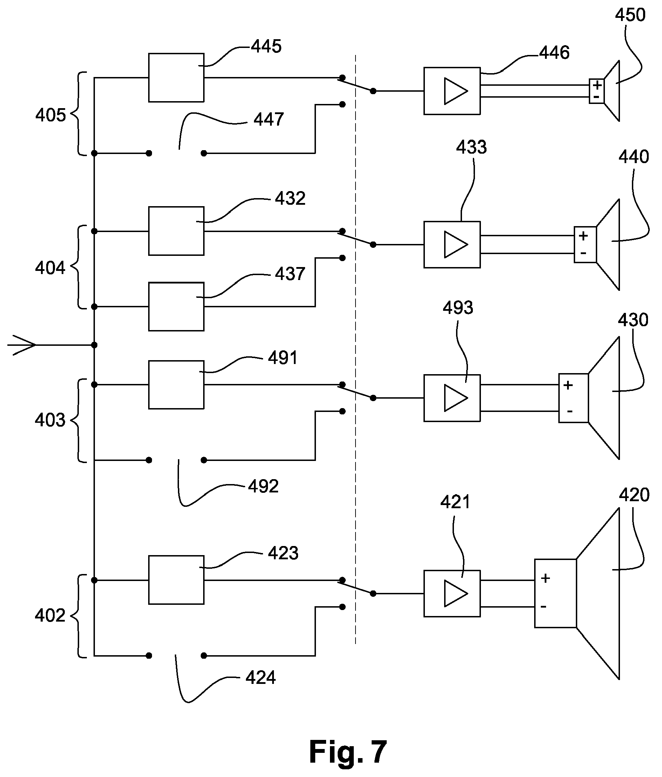

Dans l'exemple illustré à la figure 7, l'enceinte comporte également quatre voies **402,403,404,405.** En mode nominal, c'est-à-dire lorsque toutes les voies fonctionnent, chaque voie possède son étage de filtrage **423,491,432,445** permettant de tirer le meilleur de performances des haut-parleurs correspondants **420,430,440,450.**

Lorsque le mode « voicing » est activé, seule la voie **404** dédiée aux médiums reste opérationnelle, alors les trois autres voies **402,403,405** sont déconnectées comme représenté par l'insertion des circuits ouverts **447, 492, 424.** Dans ce cas, le rendu sonore est celui d'un haut parleur seul, ce qui permet d'émuler les systèmes audio de petit électroménager, tels que les radioréveils par exemple. L'étage de filtrage **437** modifié pour la voie de médium peut être choisi pour assurer le rendu sonore le plus proche de l'appareil à émuler. Ce filtrage peut se déduire du filtrage **432** opérationnel en mode nominal selon plusieurs principes. Dans le cas où l'appareil à émuler présente une faible bande passante, seul l'équilibre tonal est adapté, tandis que les fréquences de coupures sont conservées. Des « accidents » peuvent être ajoutés sur la réponse en fréquence, pour s'écarter de la réponse optimisée du filtrage **432,** qui possède un plateau relativement constant entre les fréquences de coupure. Il est également possible d'élargir la bande passante, vers le haut et/ou vers le bas en fonctions des caractéristiques recherchées.

Il ressort de ce qui précède que l'enceinte conforme à l'invention permet de commuter entre un fonctionnement nominal utilisant l'intégralité des voies disponibles vers un mode à nombre de voies réduit, dans lequel certains haut-parleurs dédiés aux voies maintenues ont une réponse en fréquences élargie. De cette manière, on peut évaluer le résultat de la prise de son ou plus généralement de la reproduction sonore tout en vérifiant la qualité de transfert sur une émulation de système comportant un nombre de voies moindre.

## Revendications

1. Enceinte acoustique (1) comportant au moins deux voies (2, 3, 4), dans laquelle une première (2) et une seconde (3) voies sont dédiées respectivement à une première et une seconde bande de fréquence distinctes et adjacentes, chacune de ces voies (2,3) incluant un étage de filtrage alimenté par le signal de commande (6) et un haut-parleur (20, 30, 40), l'enceinte acoustique comprenant en outre des moyens (10) pour simultanément déconnecter la première voie (2) du signal de commande (6) et modifier l'étage de filtrage (34, 37) de la seconde voie afin de modifier sa réponse en fréquence, en déplaçant la fréquence de coupure de la seconde voie (3) en direction de la bande de fréquence dédiée à la première voie (2), **caractérisé en ce que** la bande de fréquence de la seconde voie (3) est supérieure à la bande de fréquence de la première voie (2)

2. Enceinte acoustique selon la revendication 1, **caractérisée en ce que** la modification de la réponse en fréquence inclut une modification de l'équilibre tonal sur tout ou partie de la bande passante.

3. Enceinte acoustique selon la revendication 1, **caractérisée en ce que** l'étage de filtrage (37) de la seconde voie (3) comporte un filtre passe-haut, avec une fréquence de coupure basse F_{OFF} et **en ce que** l'étage de filtrage (34) modifié de la seconde voie (3) comporte un filtrage passe haut (35) avec une fréquence de coupure basse F_{ON} inférieure à F_{OFF},

4. Enceinte acoustique selon la revendication 3, **caractérisée en ce que** l'étage de filtrage (34) modifié de la seconde voie (3) comporte un filtrage avec une atténuation constante (36) à une fréquence F_{LS} inférieure à F_{ON}.

5. Enceinte acoustique selon la revendication 1, **caractérisée en ce que** la seconde voie (3) comporte deux circuits de filtrage (34, 37) alimentés en entrée par le même signal, et dont les sorties sont connectées alternativement au haut-parleur (30) selon l'état d'un commutateur (10).

## Patentansprüche

1. Lautsprecherbox (21), die mindestens zwei Wege (2, 3, 4) umfasst, von denen ein erster (2) und ein zweiter (3) Weg für jeweils ein erstes und ein zweites Frequenzband vorgesehen sind, die verschieden sind und nebeneinander liegen, wobei jeder dieser Wege (2, 3) eine vom Steuersignal (6) gespeiste Filterstufe und einen Lautsprecher (20, 30, 40) umfasst, wobei das akustische Gehäuse außerdem Vorrichtungen (10) umfasst, um gleichzeitig den ersten Weg vom Steuersignal (6) zu trennen und die Filterstufe des zweiten Wegs (34, 37) zu verändern, um seinen Frequenzgang zu verändern, indem die Grenzfrequenz des zweiten Weges (3) in Richtung des zu dem ersten Weg (2) bestimmten Frequenzbandes verschoben wird, **dadurch gekennzeichnet, dass** das Frequenzband des zweiten Weges (3) höher ist, als das Frequenzband des ersten Weges (2).

2. Lautsprecherbox gemäß Anspruch 1, **dadurch gekennzeichnet, dass** die Änderung des Frequenzgangs eine Änderung der tonalen Balance auf der gesamten oder von Teilen der Bandbreite beinhaltet.

3. Lautsprecherbox gemäß Anspruch 1, **dadurch gekennzeichnet, dass** die Filterstufe (37) des zweiten Weges (3) einen Hochpass mit einer niedrigen Grenzfrequenz F_{OFF} enthält und dass die geänderte Filterstufe (34) des zweiten Weges (3) eine Hochpassfilterung (35) mit einer Grenzfrequenz F_{ON} die kleiner ist als F_{OFF}.

4. Lautsprecherbox gemäß Anspruch 3, **dadurch gekennzeichnet, dass** die geänderte Filterstufe (34) des zweiten Weges (3) eine Filterung mit konstanter Dämpfung (36) mit einer Frequenz F_{LS} kleiner als F_{LN} umfasst.

5. Lautsprecherbox gemäß Anspruch 1 **dadurch gekennzeichnet, dass** der zweite Weg (3) zwei Filterkreise (34, 37) umfasst, die am Eingang vom selben Signal gespeist werden und deren Ausgänge alternativ je nach dem Zustand eines Schalters (10) mit dem Lautsprecher (30) verbunden sind.

## Claims

1. A speaker system (1) comprising at least two channels (2, 3, 4), wherein a first (2) and a second (3) channels are respectively dedicated to a first and a second different and adjacent frequency bands, each of these channels (2, 3) comprising a filtering stage supplied with the control signal (6) and a driver (20, 30, 40), the speaker system further comprising means (10) for simultaneously:
▪ disconnecting the first channel (2) from the control signal (6); and
▪ modifying the filtering stage (34, 37) of the second channel to modify its frequency response, by displacing the cut-off frequency of the second channel (3) towards the frequency band dedicated to the first channel (2).
**characterized in that** the frequency band of the second channel (3) is higher than the frequency band of the first channel (2).

2. The speaker system of claim 1, **characterized in that** the modification of the frequency response comprises modifying the tonal balance on all or part of the bandwidth.

3. The speaker system of claim 1, **characterized in that** the filtering stage (37) of the second channel (3) comprises a high-pass filter, with a low cut-off frequency F_{OFF} and **in that** the modified filtering stage (34) of the second channel (3) comprises a high-pass filter (35) with a low cut-off frequency F_{ON} smaller than F_{OFF}.

4. The speaker system of claim 3, **characterized in that** the modified filtering stage (34) of the second channel (3) comprises a filtering with a constant attenuation (36) at a frequency F_{LS} smaller than F_{ON}.

5. The speaker system of claim 1, **characterized in that** the second channel (3) comprises two filtering circuits (34, 37) supplied at their input with the same signal, and having their outputs alternately connected to the driver (30) according to the state of a switch (10).
